# FASCICULE DE BREVET EUROPEEN

(11) **EP 3 415 369 B1**
(45) Date de publication et mention de la délivrance du brevet: **19.08.2020**
(21) Numéro de dépôt: 18172672.0
(22) Date de dépôt: 16.05.2018
(51) Int. Cl.: B60R 1/00, G03B 17/55, H05K 5/00

(54) **ENSEMBLE DE BOÎTIER ÉLECTRONIQUE, RACCORDEMENT ÉLECTRIQUE ET MÉTHODE D' ASSEMBLAGE**
ELEKTRONISCHE GEHÄUSEEINHEIT, ELEKTRISCHER ANSCHLUSS UND MONTAGEMETHODE
ELECTRONIC HOUSING ASSEMBLY, ELECTRICAL CONNECTOR AND ASSEMBLY METHOD

(30) Priorité: 01.06.2017 FR 1754882
(43) Date de publication de la demande: 19.12.2018
(73) Titulaire: Aptiv Technologies Limited, St. Michael (BB)
(72) Inventeur: ZUROWSKI, Miroslaw J., 30-348 Krakow (PL); POREDA, Witold, 12-221 RUCIANE NIDA (PL); RAFALOWSKI, Arkadiusz, 32-064 BRZEZINKA (PL)
(74) Mandataire: Vigand, Philippe

(56) Documents cités:
- WO-A1-2016/164173
- DE-A1-102015 116 962
- US-A1- 2012 170 119
- US-A1- 2014 060 582

## Description

### DOMAINE TECHNIQUE

La présente invention concerne un ensemble de boîtier électronique et son raccordement électrique avec une carte à circuit imprimé.

### ARRIERE-PLAN TECHNOLOGIQUE DE L'INVENTION

Les organes électroniques pour véhicule automobile et agencés à l'extérieur des véhicules doivent subir les contraintes environnementales telles que la chaleur, le froid, la glace et aussi la pluie. Afin de ne pas subir les effets persistant de ces contraintes, ces organes électroniques sont généralement équipés dispositifs électriques permettant de se débarrasser des effets de ces contraintes. On peut par exemple trouver des organes électroniques munis de dispositifs électriques tels que par exemple des refroidisseurs, des essuies glace, ou encore des éléments chauffant pour combattre le gel.

Le pilotage de ces dispositifs électriques est généralement réalisé par le biais de faisceaux électriques et de connecteurs reliant une carte de contrôle électronique et les dispositifs électriques.

Le document US2014/060582 A1 décrit un ensemble de boîtier électronique d'une caméra pour véhicule automobile comprenant une partie supérieure de boîtier et une base inférieure de boîtier logeant une carte de circuit imprimé dont une face porte un composant électronique. Des éléments de connexion d'un dispositif de chauffage sont surmoulés sur une paroi interne cylindrique de la partie supérieure de boîtier et pourvus d'extrémités reçues dans des ouvertures ménagées dans la carte de circuit imprimé.

Le document DE 10 2015 116962 A1 décrit un autre ensemble de boîtier électronique d'une caméra pour véhicule automobile.

Le document US 2012/170119 A1 décrit un dispositif de désembuage et de dégivrage pour lentille de caméra, qui comprend un dispositif de chauffage raccordé à une carte de circuit imprimé.

Le document WO 2016/164173 A1 décrit aussi un dispositif de chauffage pour une caméra de véhicule automobile, qui comprend un élément chauffant destiné à chauffer une fenêtre transparente placée à l'avant d'une lentille sans bloquer une image reçue par l'objectif de la caméra.

Les solutions actuelles de raccordement électrique de ces dispositifs électriques sont encombrantes, couteuses et lourdes.

Il est donc important de proposer une solution nouvelle résolvant ces problèmes.

### RESUME DE L'INVENTION

Selon l'invention, un ensemble de boîtier électronique comprend une carte à circuit imprimé comprenant une partie principale rigide dont au moins une face comporte un composant électronique et comprenant au moins une partie flexible agencée en périphérie de la partie rigide, la partie flexible comprenant au moins un plot de raccordement électrique; un élément de boîtier supérieur comprenant une première paroi cylindrique qui est insérée dans un élément de boîtier inférieur) comprenant une seconde paroi cylindrique. La partie flexible s'étend entre la première et la seconde parois cylindriques, et le plot de raccordement électrique de la partie flexible est en contact électrique avec une surface de contact électrique qui est agencée sur la face externe de la première paroi cylindrique ou sur la face interne de la seconde paroi cylindrique.

La partie flexible peut être constituée par une languette flexible qui s'étend globalement dans le plan de la partie principale de la carte à circuit imprimé avant le montage de la carte à circuit imprimé dans l'ensemble de boîtier électronique.

La partie flexible peut être formée par une partie amincie du substrat formant la partie principale de la carte à circuit imprimé.

La partie principale de la carte à circuit imprimé peut être fixée sur un bord d'extrémité libre de la première paroi cylindrique et peut s'étendre dans un plan sensiblement transversal à l'axe vertical de la première paroi cylindrique.

La première et la seconde paroi cylindriques peuvent comporter chacune au moins une surface de contact électrique sensiblement plane et la partie flexible peut être maintenue pincée entre lesdites surfaces de contact planes.

Le plot de raccordement électrique de la partie flexible est de forme bombée de sorte à renforcer le contact électrique entre le plot de raccordement électrique de la partie flexible et la surface de contact électrique de la paroi cylindrique associée.

L'élément de boîtier supérieur peut comporter un support de lentille et la partie principale de la carte à circuit imprimé peut comporter un circuit électronique de capture d'images.

La surface de contact électrique qui est agencée sur la face externe de la première paroi cylindrique peut être reliée électriquement à un dispositif électrique, tel qu'un dispositif de chauffage, agencé sur le support de lentille.

Selon l'invention, une méthode d'assemblage d'un ensemble de boîtier électronique tel que décrit ci-dessus comporte les étapes suivantes :
fournir une carte à circuit imprimé comprenant une partie principale rigide et comprenant au moins une partie flexible ;
fixer la partie principale de la carte à circuit imprimé sur un bord d'extrémité libre de la première paroi cylindrique d'un élément de boîtier supérieur dans un plan sensiblement transversal à l'axe de la première paroi cylindrique;
glisser la première paroi cylindrique dans un élément de boîtier inférieur et contre la seconde paroi cylindrique de l'élément de boîtier inférieur de sorte à venir plier verticalement la partie flexible; et
insérer la première paroi cylindrique dans l'élément de boîtier inférieur et contre la seconde paroi cylindrique de l'élément de boîtier inférieur de sorte à venir pincer la partie flexible entre la première et la seconde parois cylindrique.

D'autres buts et avantages de la présente invention apparaîtront au vu de la description qui suit.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue schématique en perspective éclatée de l'ensemble de boîtier électronique selon l'invention.
- La figure 2 est une vue schématique en perspective en coupe transversale de l'ensemble de boîtier électronique de la figure 1 assemblé.
- La figure 3 est une vue schématique en perspective en coupe transversale de l'ensemble de boîtier électronique de la figure 1 assemblé selon laquelle le corps du connecteur est représenté sans l'ensemble de terminaux électriques.
- La figure 4 est une vue schématique en perspective du boîtier inférieur et de son fond de boîtier de l'ensemble de boîtier électronique de la figure 1, le fond de boîtier étant représenté avec les contacts électriques de l'ensemble de terminaux électriques.
- La figure 5 est une vue schématique en perspective en coupe transversale du boîtier supérieur assemblé avec la première carte à circuit imprimé, la coupe transversale permettant de visualiser le conduit du boîtier supérieur.
- La figure 6 est une vue schématique en perspective en coupe transversale du boîtier supérieur de la figure 5 assemblé avec le boîtier inférieur de l'ensemble de boîtier électronique de l'invention.
- La figure 7 est une vue schématique en perspective de la face supérieure de la première carte à circuit imprimé de l'ensemble de boîtier électronique e de la figure 1.
- La figure 8 est une vue schématique en perspective de la face inférieure de la première carte à circuit imprimé de l'ensemble de boîtier électronique de la figure 1.
- La figure 9 est une vue schématique en perspective en coupe transversale d'une étape intermédiaire d'insertion du boîtier supérieur avec le boîtier inférieur de l'ensemble de boîtier électronique de la figure 1.
- La figure 10 est une vue schématique partielle en perspective en coupe transversale de l'ensemble de boîtier électronique de la figure 1 assemblé illustrant la liaison électrique de la première carte à circuit imprimé avec le boîtier supérieur et avec le boîtier inférieur.
- La figure 11 est une vue schématique agrandie de la figure 10 au niveau de la liaison électrique de la première carte à circuit imprimé avec le boîtier supérieur et avec le boîtier inférieur.
- La figure 12 est une vue schématique en perspective du boîtier supérieur équipé de traces électriquement conductrices.
- La figure 13 est une vue schématique en perspective du boîtier supérieur équipé de traces électriquement conductrices et équipé de la première carte à circuit imprimé dont les parties flexibles sont représentées en contact avec les traces électriquement conductrices.
- La figure 14 est une représentation schématique de l'élément de chauffage et de son système d'alimentation électrique.
- Les figures 15, 16, 17 et 18 sont des vues schématiques en perspectives du boîtier supérieur selon quatre étapes de réalisation des traces conductrices et des couches de protection de l'ensemble de boîtier électronique selon l'invention.
- La figure 19 est une vue schématique en perspective partiellement éclatée de l'ensemble de boîtier électronique 10 de l'invention illustrant une méthode d'assemblage de l'ensemble de boîtier électronique.
- La figure 20 est une vue schématique en perspective de l'ensemble de boîtier électronique assemblé.

### DESCRIPTION DES MODES DE REALISATION PREFERES

Afin de faciliter la description, et de façon non limitative, un repère orthogonal comprenant un axe longitudinal L, un axe transversal T et un axe vertical V est défini. Des orientations « bas », « haut », « dessus », « dessous », « inférieure » et « supérieure » sont définies selon la direction verticale. Des orientations « gauche », « droite » et « latérale » sont définies selon la direction transversale. Des orientations « avant » et « arrière » sont également définies selon la direction longitudinale.

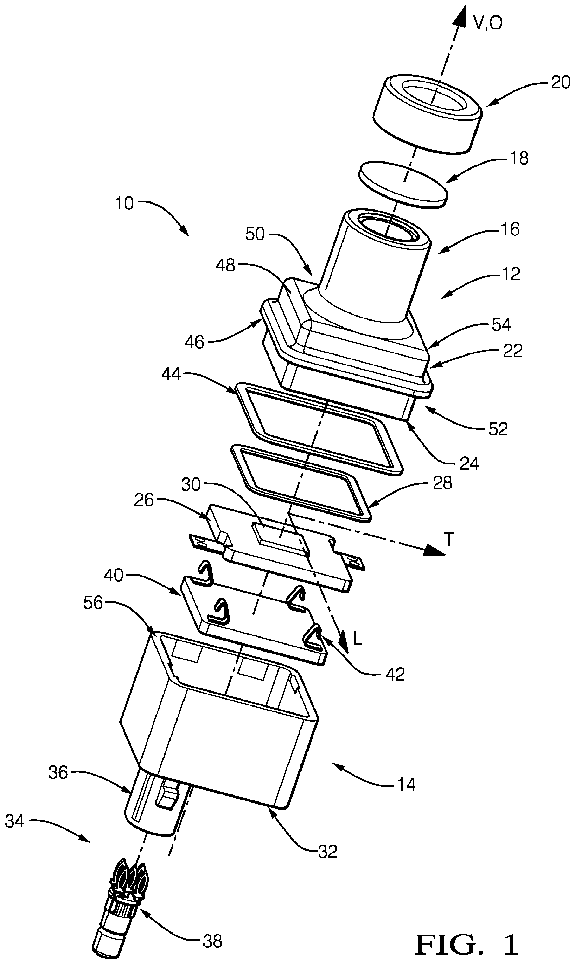

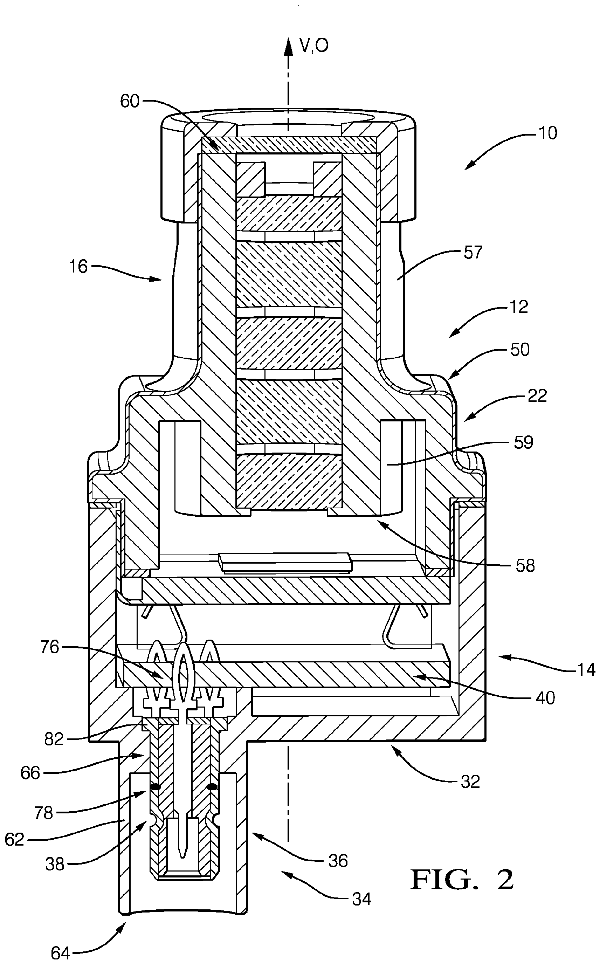

Selon la figure 1 et la figure 2, un ensemble de boîtier électronique 10 formant un dispositif optique et plus particulièrement formant une caméra pour véhicule est représentée. Ce type de caméra est prévu pour être monté à l'extérieur du véhicule et donc subir les conditions extérieures au véhicule tel que le climat.

Selon la figure 1, l'ensemble de boîtier électronique 10 comprend un boîtier supérieur 12 et un boîtier inférieur 14.

Le boîtier supérieur 12 comporte un support de lentilles 16 tubulaire s'étendant selon l'axe vertical V, surmonté d'une glace de protection 18 maintenue sur le support de lentilles 16 par un capot de maintien 20. Le boîtier supérieur 12 comporte également une base 22 cylindrique, s'étendant également selon l'axe vertical V et comprenant une paroi d'extrémité supérieure 50 et une extrémité libre basse 24 ouverte; une première carte à circuit imprimé 26 étant prévue pour être fixée sur l'extrémité basse 24, transversalement à la paroi cylindrique 48 de la base 22, par l'intermédiaire d'un premier joint adhésif 28, de sorte à fermer hermétiquement le boîtier supérieur 12.

La première carte à circuit imprimé 26 comprend un circuit électronique de capture d'images 30 aligné avec les lentilles selon l'axe optique O de l'ensemble de boîtier électronique 10.

Le boîtier inférieur 14 est de forme cylindrique creux à base rectangulaire. Le boîtier inférieur 14 comporte un fond de boîtier 32 comprenant un connecteur 34. Le connecteur 34 comprend un corps de connecteur 36 venu de matière avec le boîtier inférieur 14 ainsi qu'un ensemble de terminaux électriques 38 prévu pour être inséré dans le corps du connecteur 36 et prévu pour être en contact électrique avec une seconde carte à circuit imprimé 40.

La seconde carte à circuit imprimé 40 comporte des moyens de connexions électriques 42 avec la première carte à circuit imprimé 26, plus particulièrement, les moyens de connexions électriques 42 sont réalisés par des languettes élastiques fixées sur la seconde carte à circuit imprimé 40 et en contact par compression avec la première carte à circuit imprimé. 26

Le boîtier supérieur 12 est fixé au boitier inférieur 14 au moyen d'un second joint adhésif 44. Plus particulièrement, la base 22 du boîtier supérieur 12 comprend un rebord 46 externe cylindrique agencé sur la surface extérieure de la paroi cylindrique 48 de la base 22 du boîtier supérieur 12. Le rebord 46 est agencé entre la paroi d'extrémité supérieure 50 et l'extrémité basse 24 de la base 22 de sorte à définir une portion haute 54 et une portion basse 52 de la base 22 du boîtier supérieur 12. La portion basse 52 de la base 22 vient s'insérer dans le boîtier inférieur 14 jusqu'à ce que le rebord 46 de la base 22 du boîtier supérieur 12 vienne en butée contre le second joint adhésif 44 agencé sur la surface supérieure de l'extrémité haute 56 du boîtier inférieur 14. La surface supérieure de l'extrémité haute 56 du boîtier inférieur 14 forme ainsi une surface d'appui.

De façon alternative, la surface d'appui du boîtier inférieur peut être agencée ailleurs que sur l'extrémité haute 56 du boîtier inférieur 14. A titre d'exemple, la surface d'appui peut être formée par un rebord interne à la surface interne 118 de la paroi cylindrique 116 du boîtier inférieur 14.

De façon optionnelle, le second joint adhésif 44 peut être réalisé par un dépôt de colle sur la surface supérieure de l'extrémité haute 56 du boîtier inférieur 14, ou encore sur le rebord 46 de la base 22 du boîtier supérieur 12.

Plus en détail et selon la figure 2, la paroi d'extrémité supérieure 50 de la base 22 du boîtier supérieur 12 est traversée par le support de lentilles 16 tubulaire. Le support de lentilles 16 s'étend selon l'axe optique O de l'ensemble de boîtier électronique 10 depuis sa première extrémité agencée à l'intérieur de la base 22 jusqu'à sa seconde extrémité 60 agencée en dehors de la paroi d'extrémité supérieure 50 de la base 22. La partie du support de lentilles 16 agencée à l'intérieur de la base 22 définie un tronçon inférieur 59 du support de lentille 16, la partie du support de lentilles 16 agencée en dehors de la base 22 définie un tronçon supérieur 57 du support de lentilles 16. Le support de lentilles 16 représenté comprend quatre lentilles globalement régulièrement espacées. Cet agencement permet une structure multi lentilles tout en minimisant la longueur, selon l'axe optique O, de l'ensemble de boîtier électronique 10.

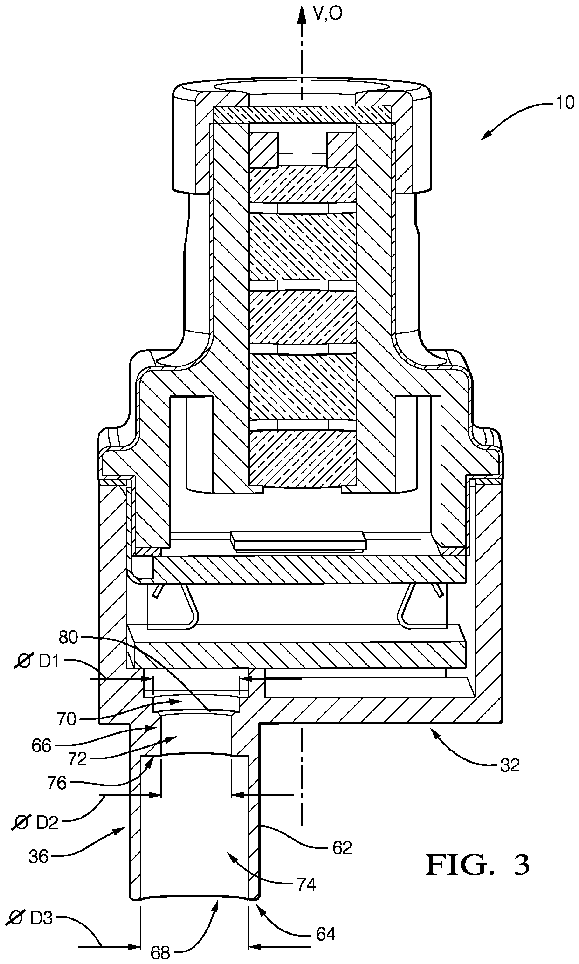

Selon la figure 2 et la figure 3, le corps du connecteur 36 comprend une paroi cylindrique 62 de base circulaire s'étendant verticalement depuis la face extérieure du fond de boitier 32 jusqu'à son extrémité libre 64 et une portion 66 creusée dans l'épaisseur du fond de boîtier 32. Le corps du connecteur 36 comprend une cavité cylindrique 68 de base circulaire comprenant trois tronçons, de diamètres différents, en continuités les uns avec les autres. La cavité à trois tronçons permet d'agencer fixement l'ensemble de terminaux électriques.

Le premier tronçon 70 est creusé globalement depuis la surface interne de la paroi du fond de boîtier 32 jusqu'à mi épaisseur de la paroi du fond de boîtier 32. Le premier tronçon 70 est un tronçon cylindrique de base circulaire comprenant un premier diamètre D1. Le second tronçon 72, en continuité avec le premier tronçon 70, forme une cavité de second diamètre D2 légèrement inférieur au premier diamètre D1. Le second tronçon 72 s'étend depuis globalement la mi épaisseur de la paroi du fond de boîtier 32 jusqu'à son extrémité 76 externe au fond de boîtier 32. Le troisième tronçon 74, en continuité avec le second tronçon 72, comprend un troisième diamètre D3 aussi bien supérieur au second diamètre D2 qu'au premier diamètre D1.

L'ensemble de terminaux électriques 38 comprend une partie supérieure formée de contacts électriques 76 insérés dans la seconde carte à circuit imprimé 40; et une seconde partie cylindrique, formant la base 78 de l'ensemble de terminaux électriques 38. Plus précisément, les contacts électriques 76 sont insérés en force dans la seconde carte à circuit imprimé 40 permettant ainsi le contact électrique entre le connecteur 34 et la seconde carte à circuit imprimé 40.

La différence entre le premier diamètre D1 et le second diamètre D2 permet à la jonction entre le premier tronçon 70 et le second tronçon 72 de la cavité 68 du corps de connecteur 36 de former une marche ou rebord cylindrique 80 sur lequel un rebord supérieur 82 de la base 78 de l'ensemble de terminaux électriques 38 vient en appui. Selon le mode de réalisation représenté, le rebord supérieur 82 de la base 78 de l'ensemble de terminaux électriques 38 est agencé à l'extrémité supérieure de la base 78.

Le diamètre D2 du second tronçon 72 est également ajusté de sorte à ce que la partie de la base 78 de l'ensemble de terminaux électriques 38 en continuité avec le rebord supérieur 82 de la base 78 de l'ensemble de terminaux électriques 38 vient s'insérer en frottement contre la paroi interne du second tronçon 72 de sorte à ne pas pouvoir pivoter latéralement.

La base 78 de l'ensemble de terminaux électriques 38 comprend enfin une extrémité basse agencée dans la troisième cavité 74 de sorte à permettre l'accouplement électrique de l'ensemble de terminaux électriques 38 avec un terminal électrique complémentaire inséré dans la troisième cavité 74.

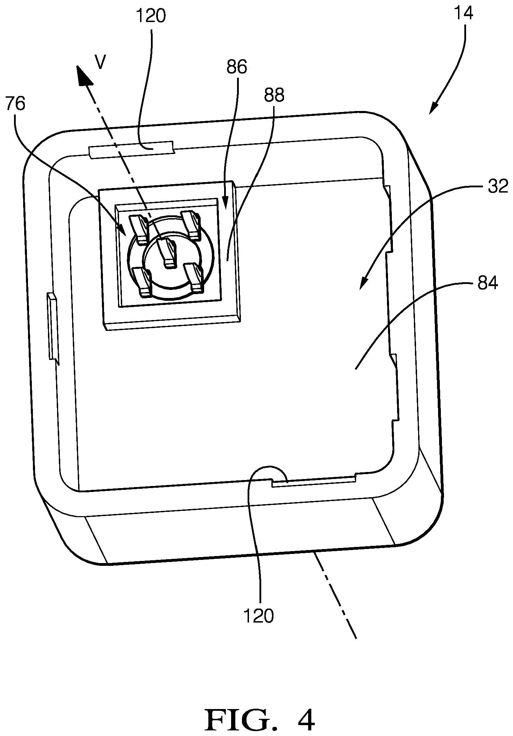

Selon la figure 4, la face interne 84 du fond de boîtier 32 comprend également une paroi cylindrique 86 de base rectangulaire interne au boîtier inférieur 14 et entourant les contacts électriques 76 de l'ensemble de terminaux électriques 38. La paroi cylindrique interne 86 au boîtier inférieur 14 est de hauteur, selon l'axe vertical V, inférieure aux contacts électriques 76 prévus pour être insérés dans la seconde carte à circuit imprimé 40, de sorte à permettre à la seconde carte à circuit imprimé 40 de venir en appui sur l'extrémité supérieure 88 de la paroi cylindrique interne 86 au boîtier inférieur 14.

Le maintien de la seconde carte à circuit imprimé 40 dans le fond du boîtier 32 est donc rendu possible par l'assemblage des contact électriques 76 dans la seconde carte à circuit imprimé 40, par l'agencement de la base 78 de l'ensemble de terminaux électriques 38 dans la cavité 68 du corps de connecteur 36 et par l'agencement de la seconde carte à circuit imprimé 40 contre l'extrémité supérieure 88 de la paroi cylindrique interne 86 au boîtier inférieur 14.

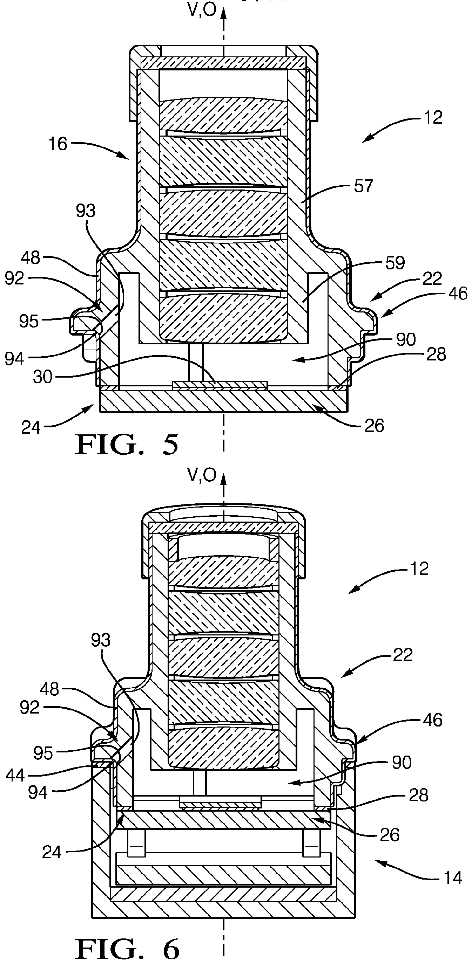

Selon la figure 5, le boîtier supérieur 12 est représenté fermé à l'extrémité basse 24 de la base 22 par la première carte à circuit imprimé 26 par l'intermédiaire du premier joint adhésif 28, formant ainsi une cavité 90 interne au boîtier supérieur 12. Plus précisément, la cavité interne 90 à la base 22 du boîtier supérieur 12 est l'espace libre délimité par la paroi cylindrique 48 de la base 22 et la première carte à circuit imprimé 26, tandis qu'un espace interne à la base cylindrique 22 est occupé par le tronçon inférieur 59 du support de lentilles 16 tubulaire agencée à l'intérieur de la base 22.

Un conduit 92 est agencé débouchant d'une part sur la face interne de la paroi cylindrique 48 de la base 22, par un orifice interne 93, et d'autre part à la jonction 94 entre la face externe de la paroi cylindrique 48 de la base 22 et la surface inférieure du rebord 46 de la base 22, par un orifice externe 95, de sorte permettre l'évacuation vers l'extérieur du boîtier supérieur 12 l'air comprimée dans la cavité 90 lors de l'assemblage du boîtier supérieur 12 avec la première carte à circuit imprimé 26.

En effet, lors du processus d'assemblage de la première carte à circuit imprimé 26 avec l'extrémité basse 24 de la base 22 du boîtier supérieur 12, l'air est comprimée dans la cavité 90. Le volume d'air augmente notamment lorsque le premier joint adhésif 28 est chauffé pour assurer son adhésion entre la première carte à circuit imprimé 26 et la base 22 du boîtier supérieur 12. L'augmentation du volume d'air, ou également sa compression dans la cavité 90 peut entrainer un déplacement des lentilles du support de lentilles 16 et donc corrompre l'alignement initial des lentilles avec le circuit électronique de capture d'image 30.

Le conduit 92 permet donc d'éliminer le risque de mauvais alignement entre les lentilles et le circuit électronique de capture d'images 30.

De façon optionnelle, le premier joint adhésif 24 peut être réalisé par un dépôt de colle sur la face inférieure de l'extrémité basse 24 de la base 22 du boîtier supérieur 12 ou par un dépôt de colle sur le pourtour de la première carte à circuit imprimé 26.

Il est à noter que selon la figure 6, lors de l'assemblage du boîtier supérieur 12 avec le boîtier inférieur 14, l'orifice externe 95 du conduit 92, débouchant sur la jonction 94 entre la face externe de la paroi cylindrique 48 de la base 22 et la surface inférieure du rebord 46 de la base 22, est bouché par le second joint adhésif 44, rendant la cavité interne 90 du boîtier supérieur 12 hermétique.

Afin d'agencer aisément l'orifice externe 95 du conduit 92, le conduit 92 est creusé de manière oblique vers le bas par rapport à l'axe optique O depuis l'orifice interne 93 vers l'orifice externe 95.

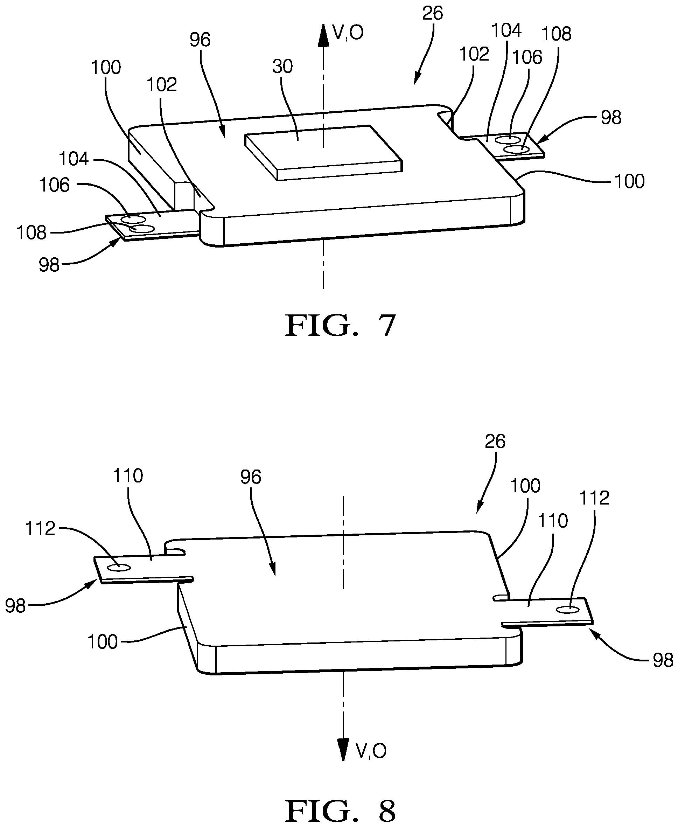

Selon la figure 7 et la figure 8, la première carte à circuit imprimé 26 est représentée avant l'assemblage complet de l'ensemble de boîtier électronique 10, c'est-à-dire avant l'assemblage du boîtier supérieur 12, dont l'extrémité basse 24 de la base 22 est fermée par la première carte à circuit imprimé 26, avec le boîtier inférieur 14. Le boîtier supérieur 12 et le boîtier inférieur 14 sont faits de métal conducteur. La première carte à circuit imprimé 26 comprend une partie principale rigide équipée du circuit électronique de capture d'images 30 et de deux parties flexibles 98 agencées de part et d'autre de la partie rigide 96. Ce type de circuit imprimé est communément appelé circuit imprimé flex-rigide. La partie flexible 98 comprend généralement un substrat amincie par rapport au substrat de la partie rigide 96. Généralement la partie flexible 98 comprend un substrat plastique sur lequel sont agencées des pistes conductrices. La partie flexible 98 est généralement constituée par une languette flexible s'étendant globalement dans le plan de la partie rigide de la carte à circuit imprimé avant son assemblage dans l'ensemble de boîtier électronique 10. La partie rigide 96 de la première carte à circuit imprimé 26 est globalement rectangulaire. Chaque partie flexible 98 est agencée sur un bord latéral 100 de la partie rigide 96. Plus particulièrement l'extrémité de jonction avec la partie rigide 96 de chaque partie flexible 98 est agencée dans une encoche 102 formée sur chaque bord latéral 100 de la partie rigide 96 de la première carte à circuit imprimé 26.

Chaque partie flexible 98 comprend sur sa face supérieure 104 un premier et un second plot de raccordement électrique 106, 108 bombés de forme globalement circulaire. Chaque partie flexible 98 comprend sur sa face inférieure 110 un troisième plot de raccordement électrique 112 bombé de forme globalement circulaire. Ces trois plots de raccordement électrique 106, 108, 112 permettent d'interfacer électriquement la première carte à circuit imprimé 26 à d'autres éléments électriques du dispositif.

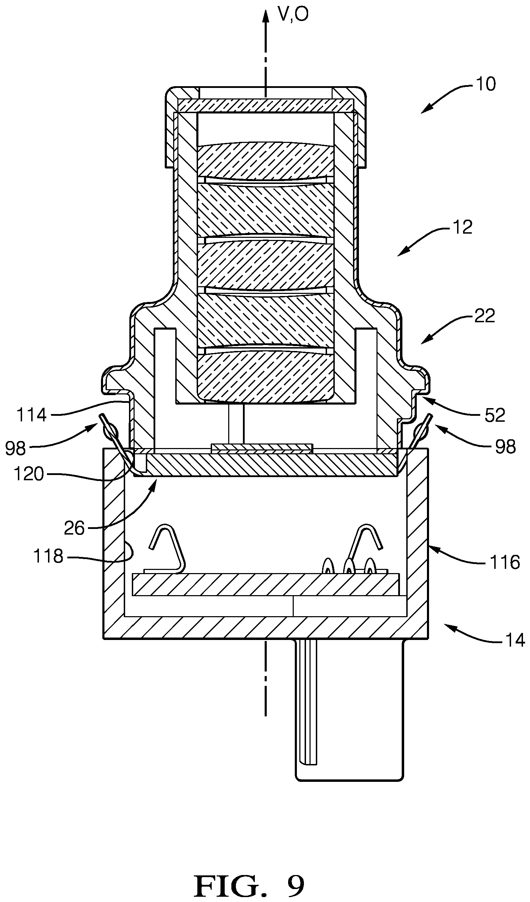

Selon le mode de réalisation représenté à la figure 9, lors de l'assemblage du boîtier supérieur 12 équipé de la première carte à circuit imprimé 26, avec le boîtier inférieur 14, c'est-à-dire lors de l'insertion de la portion basse 52 de la base 22 du boîtier supérieur 12 dans le boîtier inférieur 14, chaque partie flexible 98 de la première carte à circuit imprimé 26 vient se courber progressivement jusqu'à la verticale de sorte à être comprimée et pincée entre la surface extérieure 114 de la portion basse 52 de la base 22 du boîtier supérieur 12 et la surface interne 118 de la paroi cylindrique 116 du boîtier inférieur 14.

Afin d'éviter un endommagement de chaque partie flexible 98 de la première carte à circuit imprimé 26 lors de cette étape d'assemblage, l'extrémité haute 56 du boîtier inférieur 14 comprend deux arêtes 120 en pente inclinées formant chacune un chanfrein et orientées vers la surface interne 118 de la paroi cylindrique 116 du boîtier inférieur 14. Chaque arête 120 en pente inclinée est agencée dans l'alignement vertical de chaque partie flexible 98 de la première carte à circuit imprimé 26 de sorte, par exemple, à éviter un cisaillement de chaque partie flexible 98 lors de cette étape d'assemblage.

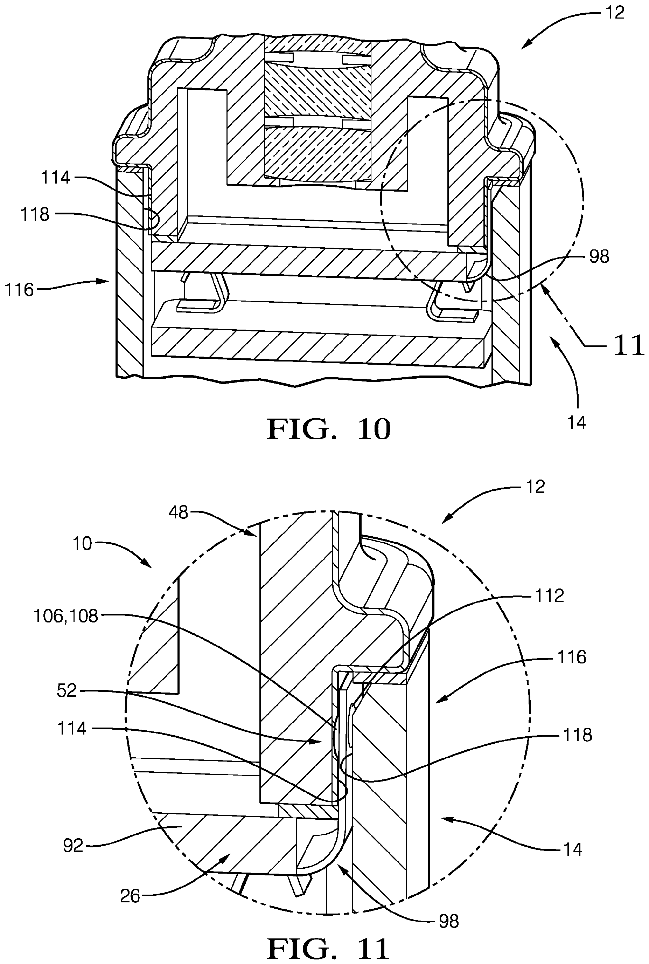

Selon la figure 10 et la figure 11, lorsque l'assemblage du boîtier supérieur 12 avec le boîtier inférieur 14 est terminé, chaque partie flexible 98 se trouve comprimée et pincée entre la surface extérieure 114 de la portion basse 52 de la base 22 du boîtier supérieur 12 et la surface interne 118 de la paroi cylindrique 116 du boîtier inférieur 14. Ainsi, le premièr et le second plot de raccordement électrique 106, 108 de chaque partie flexible 98 est en contact avec le boîtier supérieur 12; le troisième plot de raccordement électrique 112 de chaque partie flexible 98 est en contact avec le boîtier inférieur 14.

A titre d'exemple et de manière non limitative, la surface interne 118 de la paroi cylindrique 116 du boîtier inférieur 12 est en métal conducteur, de sorte qu'elle présente une surface de contact électrique plane contre laquelle chaque troisième plot de raccordement électrique 112 bombé assure une liaison électrique de masse électrique.

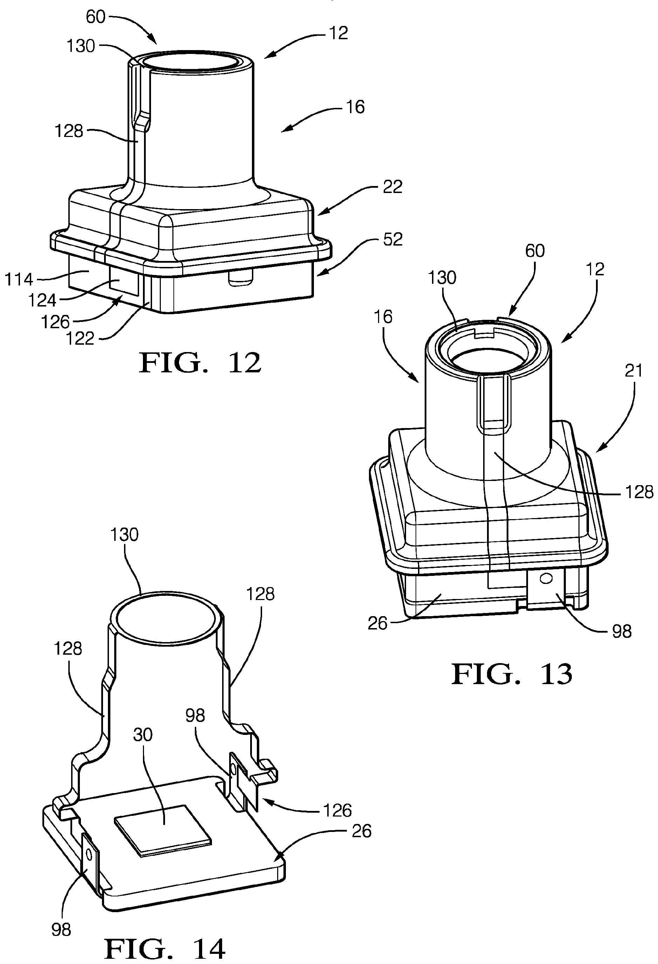

Selon le mode de réalisation de la figure 12 et de la figure 13, chaque premier plot de raccordement électrique 106 bombée de chaque partie flexible 98 de la première carte à circuit imprimé 26 est agencée contre une surface de contact électrique 122 venue de matière avec le boîtier supérieur 12 et agencée sur la surface extérieure 114 de la portion basse 52 de la base 22 du boîtier supérieur 12 de sorte à relier le boîtier supérieur 12 à la masse électrique du circuit électrique comprenant la première et la seconde carte à circuit imprimé 26, 40.

Chaque second plot de raccordement électrique 108 bombé de chaque partie flexible 98 est agencée contre une surface de contact électrique 124 plane isolée électriquement de la partie métallique du boîtier supérieur 12 et agencée sur la surface extérieure 114 de la portion basse 52 de la base 22 du boîtier supérieur 12.

Chaque surface de contact électrique 124 isolée électriquement de la partie métallique forme une extrémité de contact électrique 126 d'une trace électriquement conductrice 128 s'étendant depuis l'extrémité de contact 126 jusqu'à la seconde extrémité 60 du support de lentilles 16.

La seconde extrémité du support de lentilles 60 comporte un un élément de chauffage 130 alimenté électriquement par les traces électriquement conductrices 128 reliées électriquement à la première carte à circuit imprimé 26 par chaque second plot de raccordement électrique 108 bombé de chaque partie flexible 98 venant au contact des extrémités de contact 126.

Selon le mode de réalisation représenté à figure 13 et modélisé à la figure 14, l'élément de chauffage 130 prévu pour dégivrer, si nécessaire, la glace de protection 18 de l'ensemble de boîtier électronique 10, est une trace conductrice annulaire agencée sur le dessus de la seconde extrémité 60 du support de lentilles 16 de sorte à être au contact avec la glace de protection 18 de l'ensemble de boîtier électronique 10. Les traces conductrices 128 peuvent par exemple, et de façon non limitative, être réalisées sur une couche isolante préalablement déposée sur la surface extérieure du boîtier supérieure 12. Les traces conductrices 128 peuvent être réalisées par pulvérisation de matière conductrice telle de la peinture comprenant des microparticules conductrices, ou encore par galvanoplastie.

Alternativement, l'élément de chauffage 130 peut être tout autre dispositif électrique générant de la chaleur. A titre d'exemple, la trace annulaire agencée sur le dessus de la seconde extrémité du support de lentilles 16 peut être remplacée par un joint de colle conductrice, permettant non seulement le maintien de la glace de protection, mais aussi son échauffement par circulation de courant dans le joint de colle par le biais des traces électriquement conductrices.

Alternativement, les traces électriquement conductrices 128 peuvent alimenter tout autre type de dispositif électrique, telle que par exemple un dispositif d'essuyage ou encore essuie-glace de la vitre de protection.

Selon la figure 14, le principe de fonctionnement de l'élément de chauffage 130 consiste à faire circuler un courant électrique généré par la première carte à circuit imprimé 26 depuis le second plot de raccordement électrique 108 bombé d'une des parties flexibles 98 de la première carte circuit imprimé 26, au travers d'une des traces conductrices 128. Le courant généré continue son chemin électrique au travers l'élément de chauffage 130 formé par la trace électriquement conductrice de forme annulaire agencée sur le dessus de la paroi tubulaire du support de lentille 16. Le courant électrique fini son parcours vers la première carte à circuit imprimé au travers de l'autre trace conductrice 128 dont l'extrémité de contact 126 est au contact électrique avec le second plot de raccordement électrique 108 bombé de l'autre partie flexible 98.

L'invention ne se limite pas à l'utilisation des parties flexibles 98 de la première carte à circuit imprimé 26 comme dispositif de connexion électrique pour un dispositif optique. En effet, l'utilisation d'une carte à circuit imprimé de type flex-rigide, comprenant une partie principale rigide équipé de composants électronique et comprenant également une partie flexible 98, équipée d'au moins un plot de raccordement électrique 108, venant s'insérer compressée et pincée entre une paroi d'un élément de boîtier supérieur et une paroi d'un élément de boîtier inférieur, afin d'assurer une liaison électrique depuis la carte à circuit imprimé flex-rigide vers l'une ou l'autre paroi ou vers les deux parois, peut convenir à tout autre ensemble de boîtier électronique nécessitant une telle liaison.

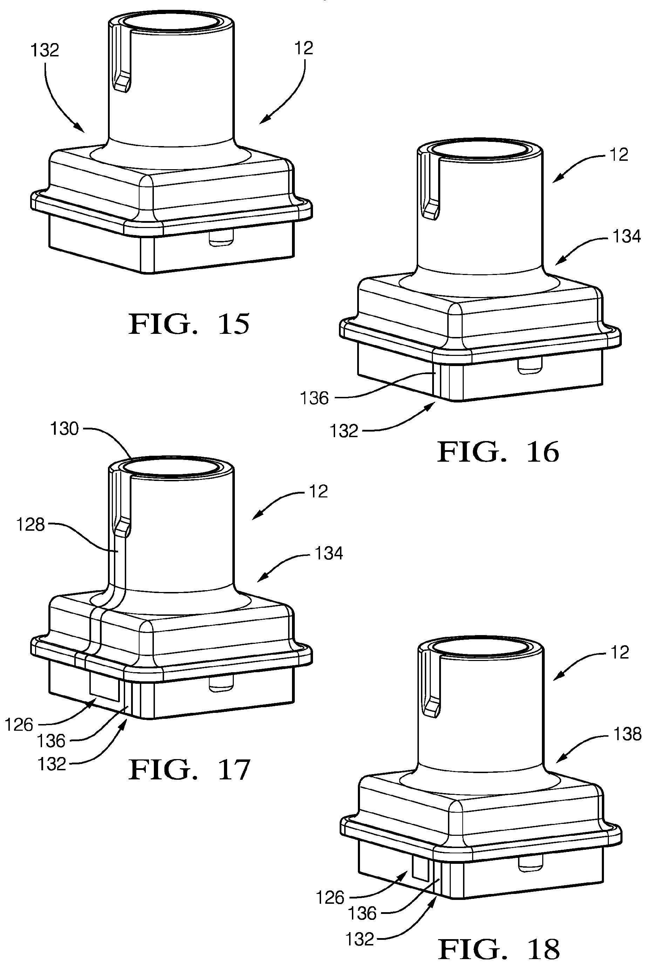

Selon la figure 15, la figure 16, la figure 17 et la figure 18, quatre étapes de réalisation de couches de protection de l'ensemble de boîtier électronique 10 sont représentés. Pour rappel, l'ensemble de boîtier électronique formant le dispositif optique est prévu pour être monté à l'extérieur d'un véhicule automobile et donc de subir toutes les contraintes environnementales extérieures au véhicule.

Selon la figure 15, le boîtier supérieur 12 est un boîtier comprenant une surface extérieure métallique telle que par exemple un alliage d'aluminium.

Selon la figure 16, la surface extérieure métallique 132 du boîtier supérieur 12 est entièrement recouverte d'une première couche 134 électriquement isolante. Seules deux surfaces de contact électrique planes 136 (une seule visible) ou zones de contact métallique ne sont pas recouvertes de la première couche 134 électriquement isolante. Ces surfaces de contact électriques planes 136 sont venues de matière avec la surface métallique 132 du boîtier supérieur 12. Ces zones de contact sont prévues pour relier le boîtier supérieur 12 à la masse électrique du circuit électrique formé par la première et la seconde carte à circuit imprimé 26, 40 par le biais des deux parties flexibles 98 de la première carte à circuit imprimé 26.

Selon la figure 17, les deux traces (une seule visible) électriquement conductrices 128 reliées à l'élément de chauffage 130 et la trace électrique annulaire, faisant fonction d'élément de chauffage 130, agencée sur le dessus de la seconde extrémité 60 du support de lentilles 16, sont réalisées par-dessus la première couche 134 électriquement isolante.

Selon la figure 18, une seconde couche électriquement isolante 138, telle un vernis, recouvre entièrement les traces électriquement conductrices 128 et ainsi que la première couche électriquement 134 isolante, à l'exception des extrémités de contacts 126 des traces électriquement conductrices 128 et à l'exception des deux surfaces de contact électrique planes 136.

Une alternative consiste à ce que la première couche 134 et la seconde couche 138 électriquement isolante recouvrent entièrement la surface extérieure métallique 132 du boitier supérieur 12, les traces électriquement conductrices 128 étant toujours réalisées entre les deux couches 134, 138 électriquement isolantes, et qu'ensuite une opération de retrait local des couches électriquement isolantes 134, 138 réalisée au moyen d'un faisceau laser permette de faire apparaître les surfaces de contacts planes 136 du boîtier métallique 132 et les extrémités de contact 126 des traces électriquement conductrices 128.

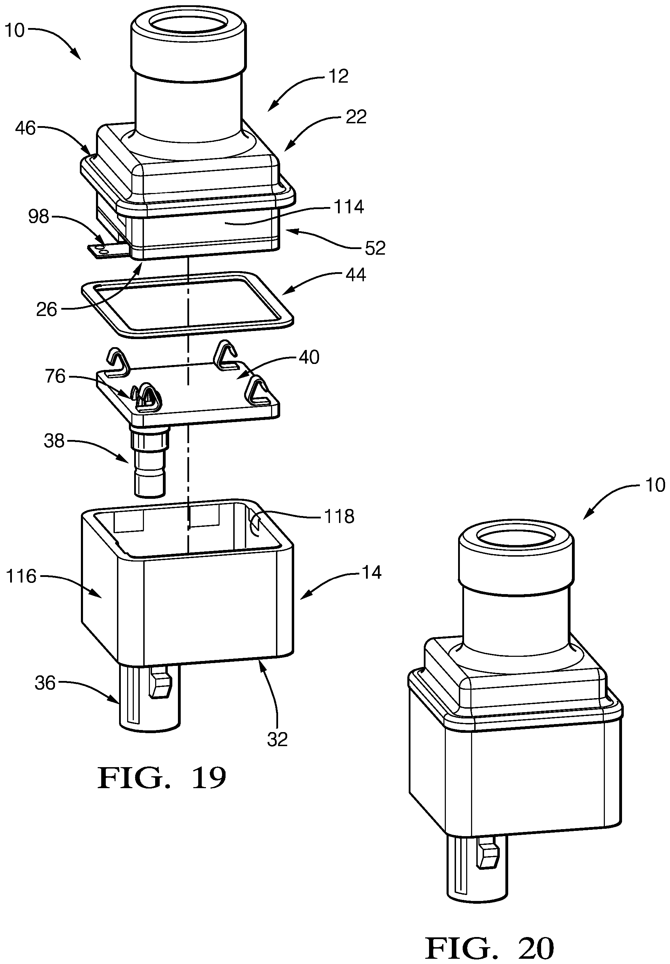

Selon la figure 19, une méthode d'assemblage de l'ensemble de boîtier électronique 10 décrit au travers de l'invention et représenté sur la figure 20 peut comprendre notamment les étapes suivantes.

Une étape consiste à insérer dans le fond de boitier 32 la seconde carte à circuit imprimé 40 préalablement équipée de l'ensemble de terminaux électriques 38 dont les contacts électriques 76 ont été insérés en force dans la seconde carte à circuit imprimé 40. Durant cette étape, le corps du connecteur 36 sert de guide d'insertion de la seconde carte à circuit imprimé 40 jusqu'à ce que la seconde carte à circuit imprimé 40 vienne en butée sur la paroi cylindrique interne 86 du boîtier inférieur 14.

Une autre étape consiste ensuite à disposer le second joint adhésif 44 sur la surface supérieure de l'extrémité haute 56 du boîtier inférieur 14.

Ensuite, une autre étape consiste à glisser et insérer la portion basse 52 de la base 22 du boîtier supérieur 12 dans le boîtier inférieur 14 jusqu'à ce que le rebord cylindrique 46 vienne en butée contre le second joint adhésif 44. Il est à noter que la première carte à circuit imprimé 26 a été préalablement assemblée sur l'extrémité basse du boîtier supérieur 12 de sorte que les parties flexibles 98 de la première carte à circuit imprimé 26 viendront tout d'abord se plier selon la direction verticale puis s'agencer pincées entre la surface extérieure 114 de la paroi cylindrique 48 de la portion basse 52 de la base 22 du boîtier supérieur 12 et la surface interne 118 de la paroi cylindrique 116 du boîtier inférieur 14 lors de l'assemblage.

## Revendications

1. Ensemble de boîtier électronique (10) comprenant :
une carte à circuit imprimé (26) comprenant une partie principale rigide (96) dont au moins une face comporte un composant électronique (30) et comprenant au moins une partie flexible (98) agencée en périphérie de la partie rigide (96), la partie flexible (98) comprenant au moins un plot de raccordement électrique (108);
un élément de boîtier supérieur (12) comprenant une première paroi cylindrique (48) qui est insérée dans un élément de boîtier inférieur (14) comprenant une seconde paroi cylindrique (116);
dans lequel la partie flexible (98) s'étend entre la première et la seconde parois cylindriques (48, 116), et le plot de raccordement électrique (108) de la partie flexible (98) est en contact électrique avec une surface de contact électrique (124) qui est agencée sur la face externe (114) de la première paroi (48) cylindrique ou sur la face interne (118) de la seconde paroi cylindrique (116).

2. Ensemble de boîtier électronique (10) selon la revendication 1 **caractérisé en ce que** la partie flexible (98) est constituée par une languette flexible qui s'étend globalement dans le plan de la partie principale (96) de la carte à circuit imprimé (26) avant le montage de la carte à circuit imprimé (26) dans l'ensemble de boîtier électronique (10).

3. Ensemble de boîtier électronique (10) selon l'une quelconque des revendications précédentes **caractérisé en ce que** la partie flexible (98) est formée par une partie amincie du substrat formant la partie principale (96) de la carte à circuit imprimé (26).

4. Ensemble de boîtier électronique (10) selon l'une quelconque des revendications précédentes **caractérisé en ce que** la partie principale (96) de la carte à circuit imprimé (26) est fixée sur un bord d'extrémité libre (24) de la première paroi cylindrique (48) et s'étend dans un plan sensiblement transversal à l'axe vertical (V) de la première paroi cylindrique (48).

5. Ensemble de boîtier électronique (10) selon l'une quelconque des revendications précédentes **caractérisé en ce que** la première et la seconde paroi cylindriques (48, 116) comportent chacune au moins une surface de contact électrique sensiblement plane (124) et **en ce que** la partie flexible (98) est maintenue pincée entre lesdites surfaces de contact planes (124).

6. Ensemble de boîtier électronique (10) selon l'une quelconque des revendications précédentes **caractérisé en ce que** le plot de raccordement électrique (108) de la partie flexible (98) est de forme bombée de sorte à renforcer le contact électrique entre le plot de raccordement électrique (108) de la partie flexible (98) et la surface de contact électrique (124) de la paroi cylindrique associée (48, 116).

7. Ensemble de boîtier électronique (10) selon l'une quelconque des revendications précédentes **caractérisé en ce que** l'élément de boîtier supérieur (12) comporte un support de lentille (16) et **en ce que** la partie principale (96) de la carte à circuit imprimé (26) comporte un circuit électronique de capture d'images (30).

8. Ensemble de boîtier électronique (10) selon la revendication précédente **caractérisé en ce que** la surface de contact électrique (124) qui est agencée sur la face externe (114) de la première paroi cylindrique (48) est reliée électriquement à un dispositif électrique (130), tel qu'un dispositif de chauffage, agencé sur le support de lentille (16).

9. Méthode d'assemblage d'un ensemble de boîtier électronique (10) selon l'une quelconque des revendications précédentes, **caractérisé en ce qu'**elle comporte les étapes suivantes :
fournir une carte à circuit imprimé (26) comprenant une partie principale rigide (96) et comprenant au moins une partie flexible (98) ;
fixer la partie principale (96) de la carte à circuit imprimé (26) sur un bord d'extrémité libre (24) de la première paroi cylindrique (48) d'un élément de boîtier supérieur (12) dans un plan sensiblement transversal à l'axe de la première paroi cylindrique (48) ;
glisser la première paroi cylindrique (48) dans un élément de boîtier inférieur (14) et contre la seconde paroi cylindrique (116) de l'élément de boîtier inférieur (14) de sorte à venir plier verticalement la partie flexible (98) ; et
insérer la première paroi cylindrique (48) dans l'élément de boîtier inférieur (14) et contre la seconde paroi cylindrique (116) de l'élément de boîtier inférieur (14) de sorte à venir pincer la partie flexible (98) entre la première et la seconde parois cylindrique (48, 116).

## Patentansprüche

1. Gehäuseelektronik-Anordnung (10) umfassend:
eine Leiterplatte (26) mit einem starren Hauptteil (96), dessen zumindest eine Seite ein elektronisches Bauelement (30) umfasst und zumindest einen flexiblen Teil (98) aufweist, der am Umfang des starren Teils (96) angeordnet ist, wobei der flexible Teil (98) zumindest einen elektrischen Steckanschluss (108) aufweist;
ein oberes Gehäuseelement (12) mit einer ersten zylindrischen Wand (48), die in ein unteres Gehäuseelement (14) mit einer zweiten zylindrischen Wand (116) eingesetzt ist;
wobei sich der flexible Teil (98) zwischen der ersten und der zweiten zylindrischen Wand (48, 116) erstreckt und der elektrische Steckanschluss (108) des flexiblen Teils (98) in elektrischem Kontakt mit einer elektrischen Kontaktfläche (124) steht, die auf der Außenseite (114) der ersten zylindrischen Wand (48) oder auf der Innenseite (118) der zweiten zylindrischen Wand (116) angeordnet ist.

2. Gehäuseelektronik-Anordnung (10) nach Anspruch 1, **dadurch gekennzeichnet, dass** der flexible Teil (98) aus einer flexiblen Lasche gebildet wird, die sich vor dem Einbau der Leiterplatte (26) in die Gehäuseelektronik-Anordnung (10) allgemein in der Ebene des Hauptteils (96) der Leiterplatte (26) erstreckt.

3. Gehäuseelektronik-Anordnung (10) nach einem der vorstehenden Ansprüche, **dadurch gekennzeichnet, dass** der flexible Teil (98) von einem verdünnten Teil des Substrats gebildet wird, das den Hauptabschnitt (96) der Leiterplatte (26) bildet.

4. Gehäuseelektronik-Anordnung (10) nach einem der vorstehenden Ansprüche, **dadurch gekennzeichnet, dass** der Hauptteil (96) der Leiterplatte (26) an einer freien Endkante (24) der ersten zylindrischen Wand (48) befestigt ist und sich in einer im Wesentlichen quer zur vertikalen Achse (V) der ersten zylindrischen Wand (48) verlaufenden Ebene erstreckt.

5. Gehäuseelektronik-Anordnung (10) nach einem der vorstehenden Ansprüche, **dadurch gekennzeichnet, dass** die erste und die zweite zylindrische Wand (48, 116) jeweils zumindest eine im Wesentlichen ebene elektrische Kontaktfläche (124) umfassen, und dass der flexible Teil (98) zwischen den ebenen Kontaktflächen (124) geklemmt gehalten wird.

6. Gehäuseelektronik-Anordnung (10) nach einem der vorstehenden Ansprüche, **dadurch gekennzeichnet, dass** der elektrische Steckanschluss (108) des flexiblen Teils (98) gewölbt ist, so dass der elektrische Kontakt zwischen dem elektrischen Steckanschluss (108) des flexiblen Teils (98) und der elektrischen Kontaktfläche (124) der zugehörigen zylindrischen Wand (48, 116) verstärkt wird.

7. Gehäuseelektronik-Anordnung (10) nach einem der vorstehenden Ansprüche, **dadurch gekennzeichnet, dass** das obere Gehäuseelement (12) einen Linsenhalter (16) umfasst, und dass der Hauptteil (96) der Leiterplatte (26) einen elektronischen Bilderfassungs-Schaltkreis (30) umfasst.

8. Gehäuseelektronik-Anordnung (10) nach dem vorstehenden Anspruch, **dadurch gekennzeichnet, dass** die elektrische Kontaktfläche (124), die auf der Außenseite (114) der ersten zylindrischen Wand (48) angeordnet ist, mit einer elektrischen Vorrichtung (130), wie beispielsweise einer Heizvorrichtung, elektrisch verbunden ist, die auf dem Linsenhalter (16) angeordnet ist.

9. Verfahren zum Zusammenbau einer Gehäuseelektronik-Anordnung (10) nach einem der vorstehenden Ansprüche, **dadurch gekennzeichnet, dass** es die folgenden Schritte umfasst:
Bereitstellen einer Leiterplatte (26), die einen starren Hauptteil (96) und zumindest einen flexiblen Teil (98) aufweist;
Befestigen des Hauptteils (96) der Leiterplatte (26) an einer freien Endkante (24) der ersten zylindrischen Wand (48) eines oberen Gehäuseelements (12) in einer im Wesentlichen quer zur Achse der ersten zylindrischen Wand (48) verlaufenden Ebene;
Schieben der ersten zylindrischen Wand (48) in ein unteres Gehäuseelement (14) und gegen die zweite zylindrische Wand (116) des unteren Gehäuseelements (14), so dass der flexible Teil (98) vertikal gebogen wird; und
Einsetzen der ersten zylindrischen Wand (48) in das untere Gehäuseelement (14) und gegen die zweite zylindrische Wand (116) des unteren Gehäuseelements (14), so dass der flexible Teil (98) zwischen der ersten und der zweiten zylindrischen Wand (48, 116) geklemmt wird.

## Claims

1. An electronic housing assembly (10) comprising:
a printed circuit board (26) comprising a main rigid part (96) at least one face of which includes an electronic component (30) and comprising at least one flexible part (98) arranged at the periphery of the rigid part (96), the flexible part (98) comprising at least one electrical connection pad (108) ;
an upper housing element (12) comprising a first cylindrical wall (48) which is inserted into a lower housing element (14) comprising a second cylindrical wall (116);
wherein the flexible part (98) extends between the first and the second cylindrical walls (48, 116), and the electrical connection pad (108) of the flexible part (98) is in electrical contact with an electrical contact surface (124) which is arranged on the outer face (114) of the first cylindrical wall (48) or on the inner face (118) of the second cylindrical wall (116).

2. The electronic housing assembly (10) according to claim 1 **characterized in that** the flexible part (98) consists of a flexible lug which generally extends in the plane of the main part (96) of the printed circuit board (26) before mounting the printed circuit board (26) in the electronic housing assembly (10).

3. The electronic housing assembly (10) according to any one of the preceding claims **characterized in that** the flexible part (98) is formed by a thinned part of the substrate forming the main part (96) of the printed circuit board (26).

4. The electronic housing assembly (10) according to any one of the preceding claims **characterized in that** the main part (96) of the printed circuit board (26) is fixed on a free end edge (24) of the first cylindrical wall (48) and extends in a plane substantially transverse to the vertical axis (V) of the first cylindrical wall (48).

5. The electronic housing assembly (10) according to any one of the preceding claims, **characterized in that** the first and the second cylindrical wall (48, 116) each include at least one substantially planar electrical contact surface (124) and **in that** the flexible part (98) is maintained pinched between said planar contact surfaces (124).

6. The electronic housing assembly (10) according to any one of the preceding claims **characterized in that** the electrical connection pad (108) of the flexible part (98) is has a domed shape so as to enhance the electrical contact between the electrical connection pad (108) of the flexible part (98) and the electrical contact surface (124) of the associated cylindrical wall (48, 116).

7. The electronic housing assembly (10) according to any one of the preceding claims **characterized in that** the upper housing element (12) includes a lens holder (16) and **in that** the main part (96) of the printed circuit board (26) includes an electronic image capture circuit (30).

8. The electronic housing assembly (10) according to the preceding claim **characterized in that** the electrical contact surface (124) which is arranged on the outer face (114) of the first cylindrical wall (48) is electrically connected to an electrical device (130), such as a heating device, arranged on the lens holder (16).

9. A method for assembling an electronic housing assembly (10) according to any one of the preceding claims, **characterized in that** it includes the following steps:
providing a printed circuit board (26) comprising a main rigid part (96) and comprising at least one flexible part (98) ;
fixing the main part (96) of the printed circuit board (26) on a free end edge (24) of the first cylindrical wall (48) of an upper housing element (12) in a plane substantially transverse to the axis of the first cylindrical wall (48);
sliding the first cylindrical wall (48) into a lower housing element (14) and against the second cylindrical wall (116) of the lower housing element (14) so as to vertically fold the flexible part (98); and
inserting the first cylindrical wall (48) into the lower housing element (14) and against the second cylindrical wall (116) of the lower housing element (14) so as to pinch the flexible part (98) between the first and the second cylindrical wall (48, 116).
